## Europäisches Patentamt

(19) **European Patent Office**

**Office européen des brevets**

(11) Numéro de publication: **0 123 571**
**B1**

(12) **FASCICULE DE BREVET EUROPEEN**

(45) Date de publication du fascicule du brevet: 24.05.89

(51) Int. Cl.⁴: **G 11 C 11/34,** G 11 C 17/00

(21) Numéro de dépôt: **84400472.1**

(22) Date de dépôt: **09.03.84**

(54) Mémoire permanente à transistors à grille flottante, électriquement reprogrammable sans effacement préalable.

(30) Priorité: **11.03.83 FR 8304048**

(43) Date de publication de la demande:
**31.10.84 Bulletin 84/44**

(45) Mention de la délivrance du brevet:
**24.05.89 Bulletin 89/21**

(84) Etats contractants désignés:
**DE FR GB IT NL**

(56) Documents cités:
**FR-A- 2 455 333**
**US-A- 4 266 283**

**PATENTS ABSTRACTS OF JAPAN, vol. 3, no. 38, 30 mars 1979, page 34E101 & JP - A - 54 16138 -02-1979**
**PATENTS ABSTRACTS OF JAPAN, vol. 3, no. 132, 6 novembre 1979, page 55E149 & JP - A - 54 110 742**

(73) Titulaire: **SGS-THOMSON MICROELECTRONICS S.A., 7, Avenue Galliéni, F-94250 Gentilly (FR)**

(72) Inventeur: **Kritter, Sylvain, THOMSON-CSF SCPI 173, bld Haussmann, F-75379 Paris Cedex 08 (FR)**
Inventeur: **Vellou, Daniel, THOMSON-CSF SCPI 173, bld Haussmann, F-75379 Paris Cedex 08 (FR)**

(74) Mandataire: **Rinuy, Santarelli, 14, avenue de la Grande Armée, F-75017 Paris (FR)**

## Description

La présente invention concerne les mémoires intégrées permanentes électriquement effaçables et reprogrammables, et plus particulièrement celles qui incorporent, comme éléments de mémorisation des transistors à grille flottante.

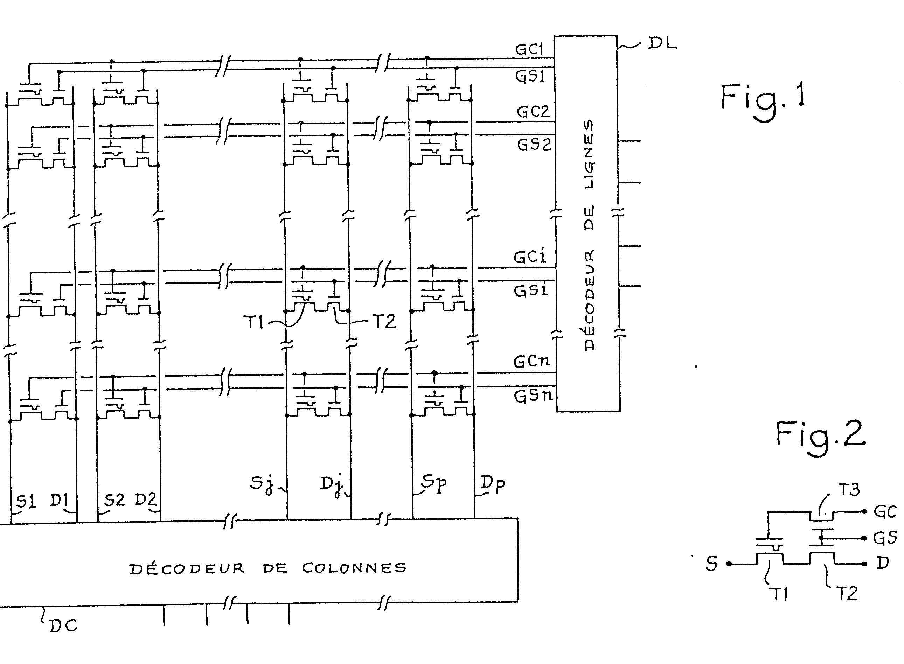

Un exemple typique d'organisation d'une mémoire de ce type est représenté à la figure 1: la mémoire comporte n lignes et p colonnes, et les colonnes sont organisées en m mots de q bits $(m \times q = p)$.

Chaque point mémoire comprend un transistor à grille flottante T1 et un transistor MOS (Metal-Oxyde-Semiconducteur), T2, en série avec le transistor à grille flottante. La mise en conduction du transistor T2 par application d'une tension appropriée sur sa grille permet de sélectionner le point mémoire correspondant pour lire son état, l'effacer, ou le réinscrire. L'application d'une tension positive suffisamment élevée entre le drain et la grille de commande du transistor à grille flottante permet l'inscription d'un état logique «0» par injection et piégeage d'électrons dans la grille flottante. Au contraire, l'application d'une tension négative permet l'inscription d'un état logique «1» par dépiégeage (évacuation) des électrons piégés.

L'organisation de la mémoire est telle que l'on puisse sélectionner une ligne (au moyen d'un décodeur de ligne DL) et, dans cette ligne un mot (au moyen d'un décodeur de colonne DC). C'est pourquoi, chaque point mémoire de rang i, j, correspondant à l'intersection d'une ligne i et d'une colonne j, est connecté de la manière suivante: la source du transistor à grille flottante T1 est reliée à un conducteur Sj, son drain est relié à la source du transistor de sélection T2 dont le drain est relié à un conducteur Dj; les deux conducteurs Sj et Dj, correspondent à une colonne de rang j de points mémoire tous connectés de la même façon à ces conducteurs qui sont reliés au décodeur de colonne DC; la grille de commande du transistor T1 est reliée à un conducteur GCi et la grille de commande du transistor de sélection T2 est reliée à un conducteur GSi; ces deux conducteurs GCi et GSi correspondent à une ligne i de points mémoire tous connectés de la même façon à ces conducteurs qui sont reliés au décodeur de ligne DL.

Sans rentrer dans les détails de fonctionnement de cette mémoire, il faut indiquer que l'écriture d'un «0» dans un point mémoire de rang i, j, nécessite:
a) en principe la mise en haute impédance du conducteur Sj, en pratique de tous les conducteurs S (Sl à Sp);
b) l'application d'une tension VH au conducteur GSi de la ligne sélectionnée et 0 aux conducteurs analogues GS correspondant aux lignes non sélectionnées (GS1 à GSn sauf GSi);
c) l'application d'une tension VH sur le conducteur GCi de la ligne sélectionnée et 0 sur les conducteurs correspodants GC des lignes non sélectionnées (GCl à GCn sauf GCi);

d) l'application d'une tension 0 sur le conducteur Dj et d'une tension de protection VH sur les conducteurs analogues D des colonnes sur lesquelles il n'y a pas lieu d'écrire un «0», et en pratique sur tous les conducteurs analogues D des colonnes correspondant aux mots non sélectionnés en écriture, c'est-à-dire sur lesquels il n'y a pas lieu d'écrire ni un «1» ni un «0».

L'écriture d'un «1» dans un point mémoire de rang i, k (même ligne i, colonne différente k) nécessite quant à elle:
a) en principe la mise en haute impédance du conducteur Sk;
b) l'application d'une tension VH au conducteur GSi et 0 aux conducteurs analogues GS correspondant aux lignes non sélectionnées;
c) l'application d'une tension 0 sur le conducteur GCi comme d'ailleurs sur les conducteurs correspondants GC des lignes non sélectionnées;
d) l'application d'une tension VH sur le conducteur Dk et l'application d'une tension 0 sur les conducteurs analogues D des colonnes sur lesquelles il n'y a pas lieu d'écrire un «1», et en pratique sur tous les conducteurs analogues D des colonnes correspondants aux mots non sélectionnés en écriture, c'est-à-dire sur lesquels il n'y a pas lieu d'écrire ni un «1» ni un «0».

On voit alors que la condition d de l'écriture d'un «1» est incompatible avec la condition d de l'écriture d'un «0» et ne permet pas d'écrire globalement un mot qui comporterait à la fois des «1» et des «0». En effet il faut, pour protéger les mots non sélectionnés, de manière à ne pas perdre l'information qu'ils contiennent, appliquer à ces mots dans un cas une tension 0 et dans l'autre une tension VH. Il en résulte que l'écriture d'un mot comprenant à la fois des «0» et des «1» doit se décomposer en deux étapes: écriture des «0» en protégeant les mots non sélectionnés par une tension de protection VH, puis écriture des «1» en protégeant les mots non sélectionnés par une tension de protection 0. En pratique on effectue un effacement général (écriture de «0» sur tous les bits du mot) puis une écriture des «1» aux positions désirées dans le mot, en protégeant les mots non sélectionnés et ceux des bits du mot sélectionné qui doivent rester à zéro, par une tension VH sur les conducteurs D correspondants.

L'inconvénient principal de ce genre de mémoire est donc leur lenteur d'écriture puisque cette écriture se fait pour chaque mot en deux temps. De plus, la mémoire est nécessairement organisée en mots de longueur et position déterminées.

La présente invention propose une mémoire organisée en matrice de points mémoire de structure telle que ces inconvénients soient éliminés.

Le point mémoire comporte un transistor à grille flottante en série avec un transistor MOS de sélection, comme le point mémoire qui vient d'être décrit, mais en outre il comporte un deuxième transistor MOS de sélection en série avec la grille de commande du transistor à grille

flottante et ayant sa propre grille de commande reliée à celle du premier transistor MOS.

L'organisation de la mémoire est alors telle qu'une ligne de points mémoires soit sélectionnée par un signal de sélection appliqué aux grilles de commande des transistors MOS, et que l'écriture d'un point mémoire quelconque se fasse à partir de deux conducteurs (constituant une colonne correspondant à ce bit) reliés respectivement aux drains des deux transistors MOS pour chaque point mémoire de la colonne, ces conducteurs recevant des tensions appropriées à transmettre respectivement, lorsque le point mémoire est sélectionné, au drain et à la grille de commande du transistor à grille flottante.

Comme on le verra, la mémoire n'est pas nécessairement organisée en mots de longueur et position déterminés: un ensemble de points quelconque d'une ligne peut être sélectionné et écrit ou lu; l'écriture se fait en un seul temps.

Les caractéristiques de la présente invention ressortent des revendications de dispositif et de procédé 1 et 3 dont les préambules correspondent au document FR-A-2 455 333.

D'autres caractéristiques et avantages de l'invention apparaîtront à la lecture de la description détaillée qui suit et qui est faite en référence aux dessins annexés dans lesquels:

– la figure 1 déjà décrite représente une mémoire classique à transistors à grille flottante;

– la figure 2 représente un point mémoire selon l'invention, à trois transistors dont un à grille flottante;

– la figure 3 représente une mémoire matricielle selon l'invention;

– la figure 4 représente une mémoire matricielle selon une variante d'organisation.

Le point mémoire selon l'invention comprend d'une part (fig. 2) un transistor T1 à grille flottante et un transistor MOS de sélection T2, agencés comme à la figure 1, c'est-à-dire en série, le drain du transistor T1 étant relié à la source du transistor T2, et d'autre part un troisème transistor MOS T3 dont la grille de commande est reliée à la grille de commande du transistor T2 et dont la source est reliée à la grille de commande du transistor T1.

La source du transistor T1 sera reliée à un conducteur S, le drain du transistor T2 à un conducteur D, et la grille du transistor T2 à un conducteur GS (comme à la figure 1); mais ici, c'est le drain du transistor T3 et non la grille de commande du transistor T1 qui sera reliée à un conducteur de commande GC.

Le fonctionnement de ce point mémoire est le suivant:

a) écriture d'un «0»:
on laisse le conducteur S en l'air (ou on le met à la masse); on met le conducteur D à un potentiel 0, on applique une tension d'écriture VH (par exemple 20 volts) à la fois au conducteur GS pour sélectionner le point mémoire et au conducteur GC; une injection d'électrons se produit dans la grille flottante du transistor T1;

celui-ci acquiert une tension de seuil VS1 plus élevée que sa tension de seuil normale.

b) écriture d'un «1»:
on cherche à éliminer les électrons piégés dans la grille flottante, pour abaisser la tension de seuil du transistor T1 à une valeur VS2 notablement plus faible que VS1 (éventuellement une tension de seuil négative, par exemple égale à –VS1); pour cela, on laisse le conducteur S en l'air (haute impédance); on porte le conducteur D à la tension d'écriture VH; on porte également le conducteur GS à la tension VH mais on met le conducteur GC à la masse.

c) protection:
si on suppose que le conducteur GS est à la tension VH, que la source est en l'air, que le conducteur GC est à la masse, et que cependant on ne veut pas écrire dans ce point mémoire, il suffit de laisser le conducteur D à zéro: il n'y aura pas écriture d'un «1» (il faudrait que le conducteur D soit à VH) mais il n'y aura pas non plus écriture d'un «0» (il faudrait que le conducteur GC soit à VH). Le point mémoire est alors protégé en écriture, il conserve son état.

d) lecture:
on applique aux grilles de commande des transistors T2 et T3 (conducteur GS) une tension de sélection VS (par exemple 5 volts); on met le conducteur S à la masse et le conducteur GC à une tension de lecture VL comprise entre VS1 et VS2, par exemple à 0 volt. Le conducteur D est relié à une charge, elle-même reliée à une tension d'alimentation. La donnée en mémoire est lue par exemple par examen du courant consommé dans la charge.

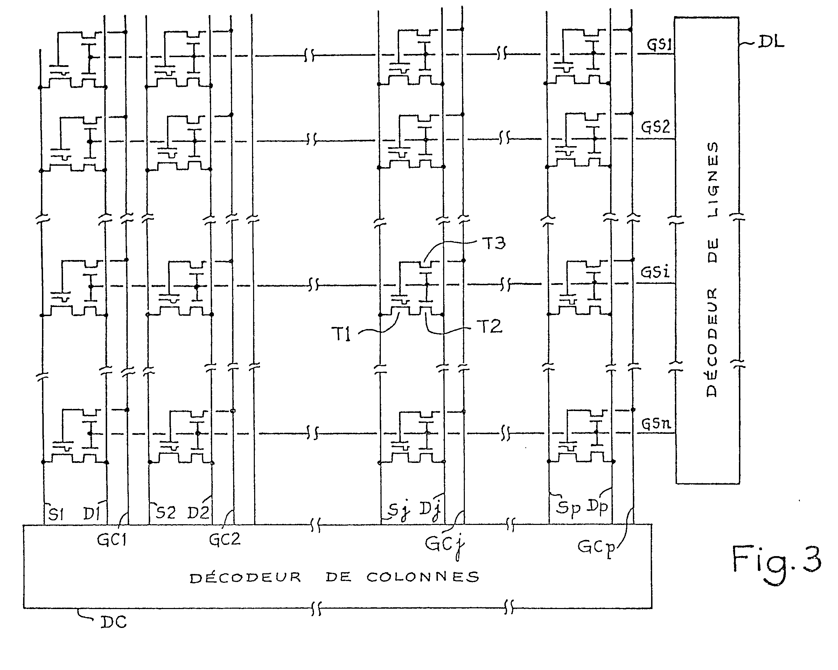

L'organisation adoptée, pour une mémoire comprenant une matrice de points à trois transistors, est représentée à la figure 3.

Il n'est plus nécessaire comme à la figure 1 de prévoir que les conducteurs GC et GS sont tous deux commandés par le décodeur de ligne; en effet, à la figure 1 il est impératif que le conducteur GC correspondant à une point mémoire donné ne soit pas porté à la tension d'écriture VH lorsque le conducteur GS correspondant à ce même point mémoire est à zéro: il y aurait une écriture de points non sélectionnés; c'est pourquoi il est exclu, pour une matrice de points à deux transistors, que par exemple ces conducteurs GS viennent du décodeur de ligne tandis que les conducteurs GC viendraient du décodeur de colonne.

Au contraire, à la figure 3, grâce au troisième transistor, il n'y a pas de possibilité que la grille de commande du transistor T1 reçoive une tension d'écriture élevée si le conducteur GS est à zéro. On peut donc prévoir une sélection de ligne par le conducteur GS et appliquer une tension désirée sur le conducteur GC à partir du décodeur de colonne.

Les conducteurs D sont aussi reliés au décodeur de colonne puisque les tensions à appliquer, en mode d'écriture, aux conducteurs GC et D sont directement liées (0, VH pour écrire un «1»; VH, 0 pour écrire un «0»; 0, 0 pour protéger le point mémoire).

Dans ces conditions, il n'est pas nécessaire d'effacer les mots de mémoire avant d'écrire, le décodeur colonne étant agencé pour fournir sur les conducteurs D et GC, simultanément pour toutes les colonnes, les couples de valeurs de tension appropriées pour l'écriture, l'effacement ou la protection.

Par conséquent, en pratique, une ligne de points est sélectionnée par un conducteur GSi d'un décodeur de ligne DL. L'ensemble des points mémoire qui ne sont pas sélectionnés en écriture reçoit d'un décodeur de colonne DC des tensions nulles sur les conducteurs Dj et GCj correspondants et il est important de remarquer qu'il n'est pas nécessaire de prévoir une organisation figée en mots de position et longueur définies à l'avance; l'ensemble des points devant être écrits à «0» reçoit 0 sur les conducteurs Dj correspondants et VH sur les conducteurs GCj; l'ensemble des points devant être écrits à «1» reçoit VH sur les conducteurs Dj correspondants et 0 sur les conducteurs GCj; et bien entendu les sources Sl à Sp sont laissées en l'air (haute impédance).

En lecture, de la même façon, une ligne de points est sélectionnée par un conducteur GSi du décodeur de ligne; un ou plusieurs points de cette ligne sont sélectionnés par le décodeur de colonne qui applique pour ces points une tension VL sur les conducteurs GCj correspondants (les sources étant à la masse et la lecture se faisant sur les conducteurs Dj correspondant aux points à lire).

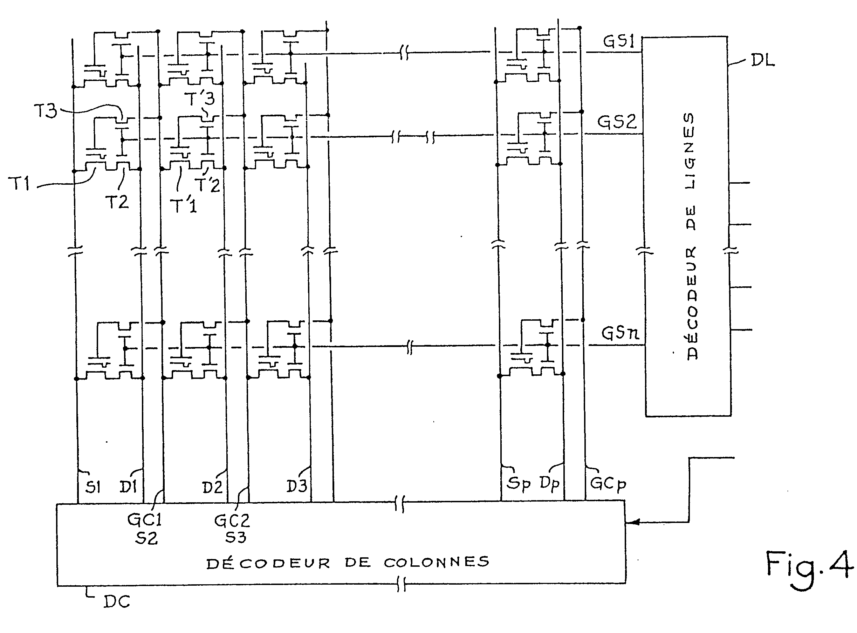

La figure 4 montre une variante d'organisation de la mémoire selon l'invention. Dans cette variante, on remarque que le conducteur GC correspondant à une colonne est confondu avec le conducteur S de la colonne de rang immédiatement supérieur: par exemple le conducteur GC1 est confondu avec le conducteur S2. Autrement dit, si on prend un point mémoire à trois transistors T1, T2, T3 appartenant à une ligne (ici la deuxième) et à une colonne (ici la première), et le point mémoire à trois transistors T'1, T'2, T'3 appartenant à la même ligne et à la colonne de rang immédiatement supérieur (colonne 2), on voit que la source du transistor T'1 est reliée à un conducteur GC1, S2 auquel est également relié le drain du transistor T3.

Cependant, on s'arrange dans le décodage pour n'avoir jamais à désigner deux colonnes consécutives de sorte qu'en l'occurrence si on cherche à écrire ou à lire le point mémoire T1, T2, T3, alors le point mémoire T'1, T'2, T'3 est inactif. Cela suppose un partage de la mémoire en deux demi-plans imbriqués l'un dans l'autre, un seul demi-plan pouvant être désigné, par exemple par un bit d'adresse spécifique.

Si la mémoire est organisée en mots, il est alors nécessaire que les bits d'un même mot ne correspondent pas à des colonnes juxtaposées; par exemple les bits consécutifs peuvent correspondre à une colonne sur deux.

Si le point mémoire T'1, T'2, T'3 est désigné en mode d'écriture, alors, les deux points mémoire adjacents de la même ligne ne le sont pas. En l'occurrence, le conducteur GC1, S2 correspondant à ce point sera mis en l'air; les conducteurs GC2 et D2 recevront un couple de potentiels 0, VH (écriture d'un «1»), ou VH, 0 (écriture d'un «0») ou 0, 0 (protection). Enfin, les conducteurs S4, S6, S8, etc. correspondant au même demi-plan mémoire que le point mémoire T'1, T'2, T'3 seront mis en haute impédance afin que les points-mémoire de l'autre demi-plan mémoire ne risquent pas de subir une inscription ou un effacement non désiré (car les sources des transistors à grille flottante de cet autre demi-plan ne sont pas en l'air mais à 0 volt ou à VH).

On notera qu'il faut que la dernière colonne de mémoire possède un conducteur GCp reliant uniquement les drains des transistors T3 des points de cette colonne.

Cette organisation de mémoire en deux demi-plans permet l'économie d'un conducteur pour chaque colonne.

Parmi les avantages de l'invention, on peut noter encore que les transistors à grille flottante se dégradent moins vite du fait que les cycles d'écriture n'entraînent une réinscription de l'état en mémoire que pour les bits qui changent de valeur, alors que dans la technique habituelle il fallait effacer tous les bits à «1» et réinscrire tous les nouveaux bits à «1».

Finalement la mémoire électriquement reprogrammable selon l'invention, avec son cycle d'écriture simplifié apparaît comme très proche d'une mémoire RAM statique non volatile.

**Revendications**

1. Mémoire permanente électriquement reprogrammable, agencée en lignes et colonnes de points-mémoire comportant chacun un transistor à grille flottante (T1) et deux transistors de sélection (T2 et T3) recevant un signal de sélection commun sur leurs grilles réunies (GSi) et connectés l'un (T2) entre un premier conducteur de colonne (Dj) et le drain du transistor à grille flottante et l'autre (T3) entre un deuxième conducteur de colonne (GCj) et la grille du transistor à grille flottante, les sources des transistors à grille flottante d'une même colonne étant reliées ensemble selon des troisièmes conducteurs de colonne (Sj), la mémoire comportant en outre un décodeur de ligne apte à appliquer une tension de sélection à un conducteur de ligne déterminée (GSi) reliant les grilles de tous les transistors de sélection de cette ligne, mémoire dans laquelle, pendant une phase d'écriture, on établit une tension nulle sur les premiers conducteurs de colonne (Dj) des colonnes correspondant à des points-mémoire non sélectionnés, des deuxièmes conducteurs de colonne (GCj) correspondant à ces mêmes colonnes étant laissés en haute impédance ou portés à une tension nulle, et caractérisée en ce qu'elle comporte un décodeur de colonne recevant indépendamment et directement chacun des conducteurs de colonne agencé pour établir simultanément, pendant une phase d'écriture unique, une différence de potentiel d'écriture (VH) entre le premier et le deuxième conducteur de colonne, pour toutes les colonnes correspondant à des points mémoires sélectionnés, cette différence de potentiel étant d'un premier signe pour l'écriture d'un «0» sur un point-mémoire déterminé et étant du signe opposé pour l'écriture d'un «1» dans un autre point-mémoire déterminé.

2. Mémoire permanente selon la revendication 1, caractérisée en ce que le deuxième conducteur de colonne d'une colonne est relié aux sources des transistors à grille flottante d'une colonne immédiatement adjacente, en ce que le décodeur de colonne est agencé pour sélectionner uniquement des mots composés de points-mémoire ne correspondant pas à des colonnes immédiatement adjacentes, et pour placer en haute impédance, pendant la phase d'écriture, les deuxièmes conducteurs de colonne des colonnes correspondant à des mots non sélectionnés.

3. Procédé de programmation d'une mémoire permanente agencée en lignes et colonnes de points-mémoire comportant chacun un transistor à grille flottante (T1) et deux transistors de sélection (T2 et T3) recevant un signal de sélection commun sur leurs grilles réunies et connectés l'un (T2) entre un premier conducteur de colonne (Dj) et le drain du transistor à grille flottante (T1) et l'autre (T3) entre un deuxième conducteur de colonne (GCj) et la grille du transistor à grille flottante, la mémoire comportant en outre un décodeur de ligne apte à appliquer une tension de sélection à un conducteur de ligne déterminé (GSi) reliant les grilles de tous les transistors de sélection de cette ligne, et un décodeur de colonne, procédé dans lequel, pendant une phase d'écriture, on établit une tension nulle sur les premiers conducteurs de colonne des colonnes correspondant à des mots non sélectionnés, les deuxièmes conducteurs de colonne correspondant à ces mêmes colonnes étant laissés en haute impédance ou portés à une tension nulle, et caractérisé en ce que l'on établit simultanément, par le moyen du décodeur de colonne, pendant une phase d'écriture unique sans effacement préalable, une différence de potentiel d'écriture (VH) entre le premier et le deuxième conducteur de colonne, pour toutes les colonnes correspondant au mot sélectionné, cette différence de potentiel étant d'un premier signe pour l'écriture d'un «0» sur un point-mémoire déterminé et étant du signe opposé pour l'écriture d'un «1».

4. Procédé selon la revendication 3, caractérisé en ce que l'on sélectionne à l'aide du décodeur uniquement des mots composés de points-mémoire ne correspondant pas à des colonnes immédiatement adjacentes les unes des autres, en ce que l'on place en haute impédance, pendant la phase d'écriture, les deuxièmes conducteurs de colonne des colonnes correspondant à des mots non sélectionnés, le deuxième conducteur de colonne de chaque colonne de la mémoire étant par ailleurs en permanence relié aux sources des transistors à grille flottante d'une colonne immédiatement adjacente.

## Claims

1. An electrically reprogrammable non-volatile memory, formed in lines and columns of memory points each comprising a floating gate transistor (T1) and two selection transistors (T2 and T3) receiving a common selection signal on their connected gates (GSi), on of them (T2) being connected between a first column conductor (Dj) and the drain of the floating gate transistor, and the other (T3) being connected between a second column conductor (GCj) and the gate of the floating gate transistor, the sources of the floating gate transistors of the same column being connected together by means of third column conductors (Sj), the memory further comprising a line decoder adapted to apply a selection voltage to a given line conductor (GSi) connecting the gates of all the selection transistors of that line, this memory being of the sort in which, during a writing phase, a zero voltage is established on the first column conductors (Dj) of the columns corresponding to the memory points which are not selected, the second column conductors (GCj) corresponding to these same columns being left at high impedance or brought to zero voltage, characterized in that it comprises a column decoder connected independently and directly to each of the column conductors and adapted to establish simultaneously, during a single writing phase, a writing potential difference (VH) between the first and the second column conductor, for all the columns corresponding to memory points selected, this potential difference being of a first sign for writing a "0" in a given memory point and being of the opposite sign for writing a "1" in another given memory point.

2. A non-volatile memory according to Claim 1, characterized in that the second column conductor of a column is connected to the sources of the floating gate transistors of an immediately adjacent column, in that the column decoder is adapted to select only words composed of memory points not corresponding to immediately adjacent columns, and to put at high impedance, during the writing phase, the second column conductors of the columns corresponding to words which are not selected.

3. A process for programming a non-volatile memory, formed in lines and columns of memory points each comprising a floating gate transistor (T1) and two selection transistor (T2 and T3) receiving a common selection signal on their connected gates (GSi), one of them (T2) being connected between a first column conductor (Dj) and the drain of the floating gate transistor (T1), and the other (T3) being connected between a second column conductor (GCj) and the gate of the floating gate transistor, the memory further comprising a line decoder, adapted to apply a selection voltage to a given line conductor (GSi) connecting the gates of all the selection transistors of that line, and a column decoder, this process being one in which, during a writing phase, a zero voltage is established on the first column conductors of the columns corresponding to the words which are not selected, the second column conductors corresponding to these same columns being left at high impedance or brought to zero voltage, characterized in that, by means of the column decoder, during a single writing phase without prior erasure, a writing potential difference (VH) is established between the first and the second column conductor, for all the columns corresponding to the word selected, this potential difference being of a first sign for writing a "0" in a given memory point and being of the opposite sign for writing a "1".

4. A process according to Claim 3, characterized in that only words not corresponding to columns immediately adjacent to one another are selected by means of the decoder, in that during the writing phase, the second column conductors of the columns corresponding to words which are not selected are put at high impedance, the second column conductor of each column of the memory in addition being permanently connected to the sources of the floating gate transistors of an immediately adjacent column.

## Patentansprüche

1. Elektrisch wiederprogrammierbarer Permanentspeicher, unterteilt in Zeilen und Spalten von Speicherpunkten, von denen jeder einen Floating-Gate-Transistor (T1) und zwei Auswahltransistoren (T2 und T3) aufweist, die ein gemeinsames Auswahlsignal an ihren verbundenen Gate-Anschlüssen (GSi) aufnehmen und die so angeschlossen sind, daß der eine (T2) zwischen einem ersten Spaltenleiter (Dj) und dem Drain des Floating-Gate-Transistors und der andere zwischen einem zweiten Spaltenleiter (GCj) und dem Gate-Anschluß des Floating-Gate-Transistors liegt, und die Source-Anschlüsse der Floating-Gate-Transistoren ein und derselben Spalte miteinander über dritte Spaltenleiter (Sj) verbunden sind, welcher Speicher darüberhinaus einen Zeilendecoder aufweist, der eine Auswahlspannung an einen bestimmten Zeilenleiter (GSi) anlegen kann, der die Gate-Anschlüsse aller Auswahltransistoren dieser Zeile verbindet, in welchem Speicher während einer Einschreibphase, eine Nullspannung auf die ersten Spaltenleiter (Dj) derjenigen Spalten gelegt wird, die den nicht-ausgewählten Speicherpunkten entsprechen, wobei zweite Spaltenleiter (GCj), die den gleichen Spalten entsprechen, bei hoher Impedanz gelassen oder auf Nullspannung gehalten werden, dadurch gekennzeichnet, daß der Speicher einen Spaltendecoder aufweist, der unabhängig und direkt jeden unterteilten Spaltenleiter aufnimmt, um während einer einzigen Einschreibphase gleichzeitig eine Einschreibpotentialdifferenz (VH) zwischen den ersten und den zweiten Spaltenleiter zu legen, wobei für alle ausgewählten Speicherpunkten entsprechenden Spalten die Potentialdifferenz ein erstes Vorzeichen für das Einschreiben einer «0» in einen bestimmten Speicherpunkt und ein entgegengesetztes Vorzeichen für das Einschreiben einer «1» in einen anderen bestimmten Speicherpunkt aufweist.

2. Permanentspeicher nach Anspruch 1, dadurch gekennzeichnet, daß der zweite Spaltenleiter einer Spalte mit den Source-Anschlüssen der Floating-Gate-Transistoren einer unmittelbar angrenzenden Spalte verbunden ist, und daß der Spaltendecoder unterteilt ist, um nur die aus Speicherpunkten zusammengesetzten Wörter auszuwählen, die nicht den unmittelbar angrenzenden Spalten entsprechen, und um während der Einschreibphase die zweiten Spaltenleiter der nicht-ausgewählten Wörtern entsprechenden Spalten auf hohe Impedanz zu bringen.

3. Verfahren zum Programmieren eines Permanentspeichers, der in Zeilen und Spalten von Speicherpunkten unterteilt ist, von denen jeder einen Floating-Gate-Transistor (T1) und zwei Auswahltransistoren (T2 und T3) aufweist, die ein gemeinsames Auswahlsignal an ihren verbundenen Gate-Anschlüssen aufnehmen und die so angeschlossen sind, daß der eine (T2) zwischen einem ersten Spaltenleiter (Dj) und dem Drain-Anschluß des Floating-Gate-Transistors (T1) und der andere (T3) zwischen einem zweiten Spaltenleiter (GCj) und dem Gate des Floating-Gate-Transistors liegt, welcher Speicher des weiteren einen Zeilendecoder, der eine Auswahlspannung an einen bestimmten die Gate-Anschlüsse aller Auswahltransistoren dieser Zeile verbindenden Zeilenleiter (GSi) anlegen kann, sowie einen Spaltendecoder aufweist, bei welchem Verfahren während einer Einschreibphase eine Spannung Null an die ersten Spaltenleiter von Spalten angelegt wird, die nicht-ausgewählten Wörtern entsprechen, und die zweiten Spaltenleiter, die den gleichen Spalten entsprechen, auf hoher Impedanz gelassen oder auf eine Nullspannung gebracht werden, dadurch gekennzeichnet, daß mithilfe des Spaltendecoders während einer einzigen Einschreibphase ohne vorheriges Löschen eine Einschreibpotentialdifferenz (VH) gleichzeitig zwischen dem ersten und dem zweiten Spaltenleiter angelegt wird, für alle dem ausgewählten Wort ensprechenden Spalten, welche Potentialdifferenz ein erstes Vorzeichen für das Einschreiben einer «0» in einen bestimmten Speicherpunkt und das entgegengesetzte Vorzeichen für das Einschreiben einer «1» aufweist.

4. Verfahren nach Anspruch 3, dadurch gekennzeichnet, daß mithilfe des Decoders nur aus solchen Speicherpunkten zusammengesetzte Wörter ausgesucht werden, die nicht unmittelbar gegenseitig benachbarten Spalten entsprechen, dadurch daß man während der Einschreibphase die zweiten Spaltenleiter von Spalten, die nicht ausgewählten Wörtern entsprechen, auf hohe Impedanz legt, wobei der zweite Spaltenleiter einer jeden Spalte des Speichers darüberhinaus permanent mit den Source-Anschlüssen der Floating-Gate-Transistoren einer unmittelbar anschließenden Spalte verbunden ist.

Fig.1

Fig.2

Fig.3

Fig.4

EP 0 123 571 B1